**Europäisches Patentamt**

**European Patent Office**

**Office européen des brevets**

(19)

(11) Veröffentlichungsnummer: **0 477 407 A1**

(12)

# EUROPÄISCHE PATENTANMELDUNG

(21) Anmeldenummer: **90118604.9**

(22) Anmeldetag: **27.09.90**

(51) Int. Cl.⁵: **H03M 1/68**, H03M 1/82

(43) Veröffentlichungstag der Anmeldung:
**01.04.92 Patentblatt 92/14**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Steinigeweg, Rolf-Jürgen, Dipl.-Ing.**
**Anna-Hermann-Strasse 46**
**W-8522 Herzogenaurach(DE)**
Erfinder: **Hügel, Harald, Dipl.-Ing.**
**Burgstaller Weg 51**
**W-8522 Herzogenaurach(DE)**

(54) **Einrichtung zum Umsetzen eines m Bit breiten Binärsignals in ein Analogsignal.**

(57) Um ein digitales Signal in ein analoges Signal umzusetzen, werden Digital-Analog-Wandler (DA) verwendet, deren Signalverarbeitungsbreite eine vorgegebene Stufigkeit bedingt. Wenn Eingangssignale (A) mit einer größeren Breite vorliegen, werden Zwischenstufen (A') nunmehr dadurch erreicht, daß entsprechend den Zwischenwerten die jeweils relativ grob umsetzbaren Digitalwerte eine Pulsbreitenmodulation auf den folgenden Stufenwert hin erhalten.

EP 0 477 407 A1

Die Erfindung bezieht sich auf eine Einrichtung zum Umsetzen eines m Bit breiten Binärsignals in ein Analogsignal unter Verwendung eines n Bit breiten Digital-Analog-Wandlers, wobei m größer als n ist.

Digital-Analog-Wandler, auch DA-Wandler genannt, werden dann eingesetzt, wenn in digitaler Form vorliegende Werte in analoge Werte umzuwandeln sind. Die Breite der zu wandelnden Binärsignale hängt dabei wesentlich von der jeweils vorliegenden Hardware, z.B. dem jeweils verwendeten Prozessor, ab. Momentan sind digitale Signale häufig als 16 Bit breite Binärsignale vorhanden. Digital-Analog-Wandler für eine derart feine Auflösung sind jedoch technisch relativ aufwendig und damit dementsprechend teuer. Es sind aber auch weniger aufwendige Digital-Analog-Wandler am Markt vorhanden, die eine geringere Auflösung von 8 Bit aufweisen. Wenn jedoch Digital-Signale mit mehr als 8 Bit Breite eine Wandlung über einen Digital-Analog-Wandler mit nur 8 Bit Breite erfahren, so muß ein Auflösungsverlust in Kauf genommen werden. Andernfalls bleibt nur die Möglichkeit, auf die wesentlich teureren höherauflösenden Digital-Analog-Wandler zurückzugreifen.

Aufgabe der Erfindung ist es, eine Einrichtung der eingangs genannten Art so auszubilden, daß die Wandlung eines Binärsignals einer vorgegebenen Breite unter Zuhilfenahme eines Digital-Analog-Wandlers mit einer demgegenüber geringen Breite ermöglicht wird, ohne daß ein Auflösungsverlust entsteht.

Gemäß der Erfindung wird diese Aufgabe dadurch gelöst, daß die n höchstwertigen Bits des Binärsignals ein Basis-Binärsignal bilden, daß die m-n niederwertigen Bits des Binärsignals ein Ergänzungs-Binärsignal bilden, daß Mittel zum Wichten der Lage des Ergänzungs-Binärsignals innerhalb des möglichen Bereiches für das Ergänzungs-Binärsignal vorgesehen sind, und daß entsprechend dem Wichtungsergebnis ein pulsbreitenmoduliertes Signal ermittelt wird, gemäß dem das Basis-Binärsignal jeweils für die Dauer jedes Impulses kurzzeitig auf einen um einen Quantisierungsprung erhöhten Wert angehoben wird.

Dieses Verfahren erhöht die Auflösung des Ausgangssignals des D/A-Wandlers in der Weise, daß die einzelnen Stufen durch eine Puls-Breitenmodulation entsprechend der Feinheit des zugeführten Digital-Signals variiert werden können, so daß sich fiktive Zwischenstufen ergeben.

Eine erste Ausbildung der Erfindung ist dadurch gekennzeichnet, daß als Mittel zum Bilden des pulsbreitenmodulierten Signals ein Taktgeber, eine Zählstufe und ein Vergleicher vorgesehen sind, wobei die Zählstufe eine Zählbreite von n-m Bit aufweist und zyklisch durch den Taktgeber fortgeschaltet wird, und wobei der Vergleicher das Ergänzungs-Binärsignal und den Zählerstand der Zählstufe miteinander vergleicht und dann, wenn das Ergänzungs-Binärsignal größer ist als der Zählerstand, ein Signal logisch "1" und andernfalls ein Signal logisch "0" liefert, das in einem Summierglied zum Basis-Binärsignal addiert wird, wobei das Ausgangssignal des Summiergliedes als Eingangssignal für den Digital-Analog-Wandler dient. Damit ist eine schaltungstechnisch ausgesprochen einfache Möglichkeit einer Pulsbreitenmodulation möglich.

Dadurch, daß das Ausgangssignal des Digital-Analog-Wandlers über einen Tiefpaß geleitet wird, ist eine einfache Art der Glättung des Analog-Signals möglich.

Es ist auch denkbar, daß zwischen den Digital-Analog-Wandler und dem Tiefpaß weitere Umsetzer geschaltet sind, um eine weitere Signalwandlung, z.B. gemäß sin- oder cos-Funktionen vorzunehmen. Eine solche Wandlung, wie diese für Zwecken der Koordinatentransformation erfolgt, kann dann ebenfalls durch PROMs mit einer geringen Breite, z.B. 8 Bit, geschehen.

Ein Ausführungsbeispiel der Erfindung ist in der Zeichnung dargestellt und wird im folgenden näher erläutert. Dabei zeigen:

FIG 1 ein Blockschaltbild und
FIG 2 signifikante Signalverläufe.

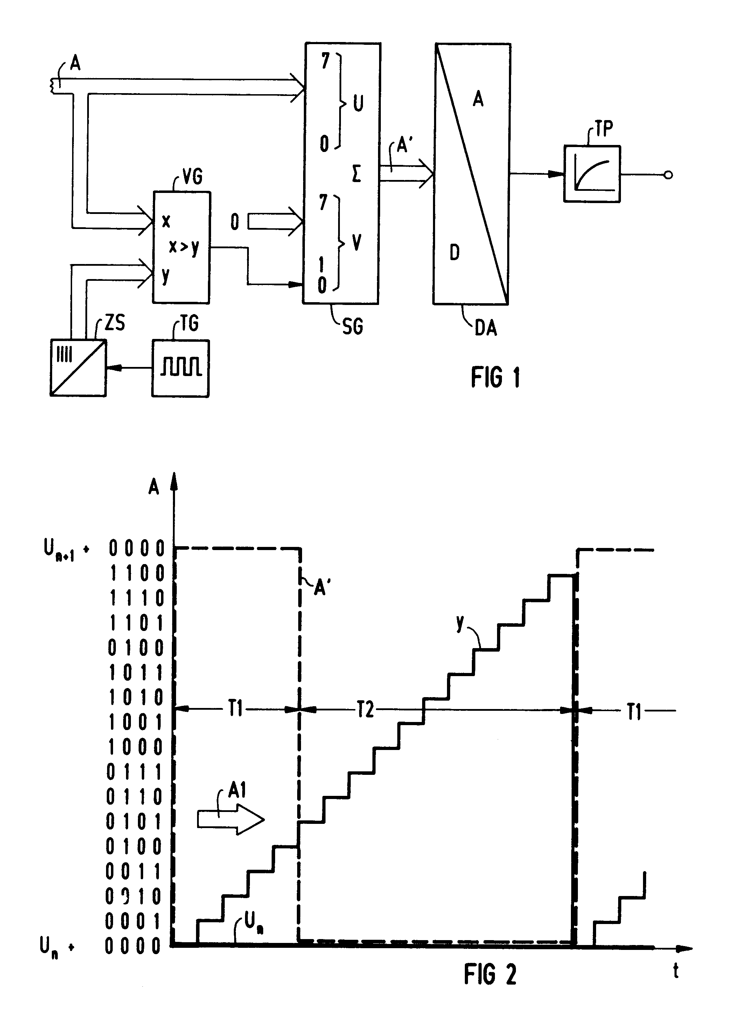

In der Darstellung gemäß FIG 1 ist ein Blockschaltbild einer erfindungsgemäßen Schaltung gezeigt, bei der als ein Eingangssignal ein 12 Bit breites Binärsignal A vorliegt, das über ein Bussystem eingespeist wird. Die 8 höchstwertigen Bits dieses Signals A werden im weiteren als Basis-Binärsignal U bezeichnet. Dieses Basis-Binärsignal U wird einem ersten 8 Bit breiten Eingang eines Summiergliedes SG zugeleitet. Die 4 niedrigwertigen Bits des Signals A werden im folgenden als Ergänzungs-Binärsignal X bezeichnet. Das Ergänzungs-Binärsignal X gelangt an einen ersten Eingang eines Vergleichers VG.

Durch einen Taktgeber TG wird eine 4 Bit breite Zählstufe ZS zyklisch fortgeschaltet und der jeweils resultierende Zählerstand Y der Zählstufe ZS wird dem zweiten Eingang des Vergleichers VG zugeleitet. Stets dann, wenn das Ergänzungs-Binärsignal X größer ist als der Zählerstand Y, wird vom Vergleicher VG ein Signal logisch "1" ausgegeben, andernfalls ein Signal logisch "0". Dieses Ausgangssignal des Vergleichers VG gelangt als weiters Eingangssignal an das Summierglied SG. Dabei stellt das Ausgangssignal des Vergleichers VG das niedrigstwertige Bit eines 8 Bit breiten Binärwortes V dar, dessen 7 höchstwertigen Bits ständig auf logisch "0" gesetzt sind. Demzufolge wird entsprechend der Größe des Ergänzungs-Binärsignals X mit einer Pulsbreitenmodulation entweder ein Wert "0" oder ein Wert "1" im Summierglied SG zum Basis-Binärsignal U addiert. Auf diesen Sachverhalt wird im folgenden anhand der FIG 2 noch näher eingegangen.

Das Ausgangssignal des Summiergliedes SG gelangt als 8 Bit breites Binärwort A' an den Eingang eines Digital-Analog-Wandlers DA, dessen Ausgangssignal über einen Tiefpaßt TP geglättet wird und dann an der Übersichtlichkeit halber nicht dargestellte weitere Verarbeitungseinrichtungen weitergeleitet wird.

Bedarfsweise kann in den Pfad zwischen Summierglied SG und dem Digital-Analog-Wandler DA noch eine weitere Signalformung, beispielsweise eine Formung entsprechend vorgegebenen Sinus- oder Cosinusfunktionen eingeschleift werden. Auch diese Maßnahme ist der Übersichtlichkeit halber jedoch im einzelnen nicht weiter ausgeführt.

In der Darstellung gemäß FIG 2 ist ein Diagramm gezeigt, das die Funktionsweise der Schaltung gemäß FIG 1 verdeutlicht. In Abszissenrichtung ist dabei die Zeit t dargestellt, in Ordinatenrichtung sind Werte für das Signal A gezeigt, die sich im Ausführungsbeispiel zwischen einem unteren Wert $U_n$ + "0000" und einem oberen Werte $U_{n+1}$ + "0000" bewegen mögen. Die Werte für $U_n$ bzw. $U_n$ + 1 bezeichnen damit ein Basis-Binärsignal und das auf diese folgende Basis-Binärsignal, während die vierstellige Binärzahl jeweil ein Ergänzungs-Binärsignal X darstellt.

Es sei nun der Fall angenommen, daß ein 12 Bit breites Binärsignal den Wert A1 annehmen möge, wie dieser Wert in der Darstellung durch einen offenen Pfeil angedeutet ist. Ein derartiges Signal spaltet sich damit in ein Basis-Binärsignal der Größe $U_n$ und ein Ergänzung-Binärsignal "0101" auf. Eine Digital-Analog-Wandlung über einen Digital-Analog-Wandler, der ausschließlich durch das Basis-Binärsignal $U_n$ gespeist wäre, würde demzufolge stets einen den Wert $U_n$ repräsentierendes Analogsignal abgeben. Ein solches Signal ist in der Zeichnung durch eine stark ausgezogene Linie angedeutet.

Nun wird jedoch bei der Erfindung stets fortlaufend die Zählstufe ZS zwischen den Binärzahlen "0000" und "1111" zyklisch fortgeschaltet, wie dies in der Darstellung durch den dünn gezeichneten Signalverlauf angedeutet ist, der als Zählerstand Y das Ausgangssignal des Zähler ZS repräsentiert. Wenn nun mittels des Vergleichers VG das Ausgangssignal Y an der Zählerstufe ZS mit dem Ergänzungs-Binärsignal X verglichen wird, zeigt sich, daß gemäß dem gewählten Beispiel während einer Zeit T1 das Ergänzungs-Binärsignal X größer ist als das Ausgangssignal Y der Zählstufe ZS und dann während eines Zeitraums T2 während des weiteren Durchlaufens des Zählers ein umgekehrter Sachverhalt vorliegt. Für den Zeitraum T1 wird nun gemäß der Erfindung zum Basis-Binärsignal U ein Wert "1" addiert und während des Zeitraums T2 wird ein Wert "0" addiert. Dieser Sachverhalt führt zu der in der Darstellung gemäß FIG 2 gezeigten gestrichelten Linie für das Ausgangssingal A' des Summiergliedes SG.

Gemäß dem Ausgangssignal A' wird nun im weiteren der Digital-Analog-Wandler DA angesteuert. Es ist somit ersichtlich, daß zwar eine Stufigkeit vorliegt, wie diese durch die Abstände zwischen den einzelnen aufeinanderliegenden Werten für das Basis-Binärsignal U gegeben ist, daß jedoch die Pulsbreitenmodulation entsprechend dem Ergänzungs-Binärsignal X auf diesen einzelnen Stufen, eine durch die zusätzliche Feinheit des Ergänzungs-Binärsignals X gegebenen fiktive Stufenanhebung bewirkt. Das heißt, je nach dem resultierenden Puls-Pausen-Verhältnis T1 zu T2 ergibt sich ein mittleres Niveau, dessen Niveausprünge durch die Feinheit des ursprünglichen Signals A gegeben ist.

Im o.a.Beispiel ist nur ein Durchlauf der Zählstufe ZS dargestellt. Es ist jedoch auch möglich, durch Wahl der Zählfrequenz über den Taktgeber TG die Anzahl der Zählzyklen pro Zeit in weiten Grenzen einzustellen.

**Patentansprüche**

1.   Einrichtung zum Umsetzen eines m Bit breiten Binärsignals in ein Analogsignal zur Verwendung eines n Bit breiten Digital-Analog-Wandlers, wobei m größer als n ist, **dadurch gekennzeichnet,** daß die n höchstwertigen Bits des Binärsignals (A) ein Basis-Binärsignal (U) bilden, daß die m-n niederwertigen Bits des Binärsignals (A) ein Ergänzungsbinärsignal (X) bilden, daß Mittel (TG,ZS,VG) zum Wichten der Lage des Ergänzungsbinärsignals (X) innerhalb des möglichen Bereiches für das Ergänzungsbinärsignal (X) vorgesehen sind und entsprechend dem Wichtungsergebnis ein pulsbreitenmoduliertes Signal ermittelt wird, gemäß dem das Basis-Binärsignal (U) jeweils für die Dauer jedes Impulses kurzzeitig auf einen um einen Quantisierungssprung erhöhten Wert angehoben wird.

2.   Einrichtung nach Anspruch 1, **dadurch gekennzeichnet,** daß als Mittel zum Bilden des pulsbreitenmodulierten Signals ein Taktgeber (TG), eine Zählstufe (ZS) und ein Vergleicher (VG) vorgesehen sind, wobei die Zählstufe (ZS) eine Zählbreite von n-m Bit aufweist und zyklisch durch den Taktgeber (TG) fortgeschaltet wird, und wobei der Vergleicher (VG) das Ergänzungsbinärsignal (X) und den Zählerstand (Y) der Zählstufe (ZS) miteinander vergleicht und dann, wenn das Erganzungsbinärsignal (X) größer ist als der Zählerstand (Y), ein Signal logisch "1" und andernfalls ein Signal logisch "0" liefert, das in einem Summierglied (SG) zum Basis-Binärsignal (U) addiert wird, wobei das Ausgangssignal des Summierglieds (SG) als Eingangssignal für den Digital-Analog-Wandler (DA) dient.

3.  Einrichtung nach Anspruch 1 oder 2, **dadurch gekennzeichnet,** daß das Ausgangssignal des Digital-Analog-Wandlers (DA) über einen Tiefpaß (TP) geleitet wird.

4.  Einrichtung nach Anspruch 3, **dadurch gekennzeichnet,** daß zwischen den Digital-Analog-Wandler (DA) und den Tiefpaß (TP) weitere Umsetzer geschaltet sind.

FIG 1

FIG 2

**Europäisches Patentamt**

**EUROPÄISCHER RECHERCHENBERICHT**

Nummer der Anmeldung

**EP 90 11 8604**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 893 102 (CANDY) <br> * Spalte 2, Zeile 61 - Spalte 6, Zeile 15; Figuren 1-2 * <br> – – – | 1-3 | H 03 M 1/68 <br> H 03 M 1/82 |
| X | DE-A-3 208 287 (STRECKENBACH) <br> * Insgesamt * <br> – – – | 1-2 | |
| X | EP-A-0 141 386 (SONY) <br> * Seite 1 - Seite 15, Zeile 9; Figuren 1-5 * <br> – – – | 1-3 | |
| A | EP-A-0 121 841 (SIEMENS) <br> – – – – – | | |

**RECHERCHIERTE SACHGEBIETE (Int. Cl.5)**

H 03 M

Der vorliegende Recherchenbericht wurde für alle Patentansprüche erstellt

| Recherchenort | Abschlußdatum der Recherche | Prüfer |
|---|---|---|
| Den Haag | 23 Mai 91 | GUIVOL Y. |